# EUROPÄISCHE PATENTANMELDUNG

(11) **EP 3 524 995 A1**
(43) Veröffentlichungstag der Anmeldung: **14.08.2019**
(21) Anmeldenummer: 18155718.2
(22) Anmeldetag: 08.02.2018
(51) Int. Cl.: G01R 33/561, G01R 33/48, G01R 33/56

(54) **VERFAHREN FÜR BESCHLEUNIGTE MAGNETRESONANZBILDGEBUNG UNTER EINSATZ VON UNIVERSALEN KALIBRIERUNGSDATEN FÜR VARIIERENDE K-RAUM-ABTASTUNG**

(71) Anmelder: Siemens Healthcare GmbH, 91052 Erlangen (DE)
(72) Erfinder: Paul, Dominik, 91088 Bubenreuth (DE); Carinci, Flavio, 91052 Erlangen (DE); Zeller, Mario, 91054 Erlangen (DE)

(57) **Zusammenfassung**

Verfahren zum Betrieb einer Magnetresonanzeinrichtung (9) bei der Aufnahme von Magnetresonanzdaten mit einer Aufnahmetechnik, bei der die kartesische Abtastung des k-Raums (1), insbesondere durch eine Rotation von Gradientenrichtungen um das k-Raumzentrum (6), für unterschiedliche Aufnahmeabschnitte jeweils eines Teils der Magnetresonanzdaten unterschiedlich vorgenommen wird, wobei die Aufnahmetechnik mit einer beschleunigenden Bildgebungstechnik kombiniert wird, für welche für jede einzelne abzutastende Schicht einen Referenzbereich (3, 3', 3") um das k-Raumzentrum (6) vollständig beschreibende Referenzdaten verwendet werden, wobei, insbesondere zu Beginn der Aufnahme, ein alle im Verlauf der Aufnahme benötigten Referenzbereiche (3, 3', 3") umfassender Kalibrierungsbereich (7) des k-Raums (1) ermittelt wird und ein Kalibrierungsdatensatz des k-Raums (1) mit der Magnetresonanzeinrichtung (9) durch vollständige, kartesische Abtastung des Kalibrierungsbereichs (7) in einer Kalibrierungsmessung aufgenommen wird, wobei Referenzdaten für jeden Aufnahmeabschnitt aus dem Kalibrierungsdatensatz ermittelt werden.

## Beschreibung

Die Erfindung betrifft ein Verfahren zum Betrieb einer Magnetresonanzeinrichtung bei der Aufnahme von Magnetresonanzdaten mit einer Aufnahmetechnik, bei der die kartesische Abtastung des k-Raums, insbesondere durch eine Rotation von Gradientenrichtungen um das k-Raumzentrum, für unterschiedliche Aufnahmeabschnitte jeweils eines Teil der Magnetresonanzdaten unterschiedlich vorgenommen wird, wobei die Aufnahmetechnik mit einer beschleunigenden Bildgebungstechnik kombiniert wird, für welche für jede einzelne abzutastende Schicht einen Referenzbereich um das k-Raumzentrum vollständig beschreibende Referenzdaten verwendet werden. Daneben betrifft die Erfindung eine Magnetresonanzeinrichtung, ein Computerprogramm und einen elektrisch lesbaren Datenträger.

Die Magnetresonanzbildgebung ist inzwischen eine etablierte Bildgebungstechnik im medizinischen Bereich. Dabei ist ein wesentliches Ziel aktueller Forschungen, Aufnahmezeiten für Magnetresonanzdaten von Patienten zu reduzieren und dennoch eine möglichst hohe Bildqualität zu erhalten. Geeignete beschleunigte Bildgebungstechniken umfassen beispielsweise die Mehrschichtbildgebung, die oft auch als SMS-Bildgebung (Simultaneous MultiSlice) bezeichnet wird. Hierbei werden mehrere Schichten innerhalb einer Repetition angeregt und die Magnetresonanzsignale aus diesen Schichten werden gleichzeitig vermessen. Anschließend werden Magnetresonanzdaten der einzelnen Schichten algorithmisch voneinander getrennt, beispielsweise unter Nutzung von Verfahren wie GRAPPA. Zur Trennung der Magnetresonanzdaten der einzelnen Schichten sind Referenzdaten für die einzelnen Schichten notwendig, welche in sogenannten Referenzmessungen gewonnen werden. Für die Referenzdaten wird üblicherweise der zentrale k-Raum um das k-Raumzentrum komplett abgetastet.

Grundsätzlich ist es bei Aufnahmen einer einzigen Schicht möglich, beispielsweise im Hinblick auf eine Unterabtastung äußerer Bereiche des k-Raums, Referenzlinien im zentralen k-Raum während der normalen Magnetresonanzdatenaufnahme aus der Schicht durch komplette Abtastung des zentralen k-Raums aufzunehmen, so dass die Referenzdaten und die Magnetresonanzdaten im gleichen Koordinatensystem vorliegen. Insbesondere dann, wenn mehrere Schichten gleichzeitig abgetastet werden, ist es bekannt, "externe" Referenzmessungen zu verwenden, die als separate Scans vor/nach der eigentlichen Magnetresonanzdatenaufnahme akquiriert werden. Die Abtastung des k-Raums erfolgt bei solchen zusätzlichen, "externen" Referenzmessungen entsprechend der Abtastung bei der Aufnahme der Magnetresonanzdaten, so dass auch hier Referenzdaten und Magnetresonanzdaten im gleichen Koordinatensystem vorliegen.

Probleme treten auf, wenn die Mehrschichtbildgebung bzw. eine solche Mehrschichttechnik oder eine andere beschleunigende Bildgebungstechnik, die Referenzdaten nutzt, mit Aufnahmetechniken kombiniert werden sollen, welche das Koordinatensystem im k-Raum während der Aufnahme der Magnetresonanzdaten zwischen unterschiedlichen Aufnahmeabschnitten verändern, insbesondere drehen. Dann müssen die Referenzdaten für jeden Aufnahmeabschnitt erneut aufgenommen werden, was einen hohen zeitlichen Aufwand zur Folge hat. Hierdurch kann der Geschwindigkeitsvorteil, der durch die beschleunigte Bildgebungstechnik gewonnen würde, verloren gehen. Weitere negative Folgen sind eine erhöhte SAR-Belastung durch die zusätzlichen Referenzmessungen und negative Effekte, die durch den T2-Zerfall bedingt sind. Zu diesen gehören entweder verstärktes Blurring bei einer erhöhten Anzahl von aufgenommenen Linien im k-Raum oder aber eine reduzierte Anzahl von aufgenommenen Linien im k-Raum, um Blurring zu vermeiden und damit eine höhere Anzahl an notwendigen Repetitionen, um einen voll abgetasteten k-Raum zu erhalten.

Ein Beispiel für eine Aufnahmetechnik, bei der die kartesische Abtastung des k-Raums in unterschiedlichen Aufnahmeabschnitten zur Bewegungskompensation verändert wird, ist die sogenannte PROPELLER-Technik, die auch als BLADE-Technik bezeichnet werden kann, vgl. hierzu beispielsweise den Artikel von J. G. Pipe, "Motion correction with PROPELLER MRI: application to head motion and free-breathing cardiac imaging", Magn. Reson. Med. 42 (1999), Seiten 963 - 969. Dabei werden insbesondere die Phasenkodierrichtung und die Ausleserichtung um das k-Raumzentrum gedreht.

Wie bereits angedeutet, werden Referenzdaten nicht nur bei der Mehrschichtbildgebung als beschleunigender Bildgebungstechnik eingesetzt, sondern auch für andere beschleunigende Bildgebungstechniken, beispielsweise Techniken der parallelen Bildgebung (PAT - Parallel Acquisition Technique), wie beispielsweise SENSE oder dergleichen. Hierbei werden Sende- und/oder Empfangsspulen mit mehreren Spulenelementen zur Bildung mehrerer Sende- und/oder Empfangskanäle verwendet. Auch für solche beschleunigende Bildgebungstechniken werden Referenzdaten aus dem k-Raumzentrum für alle abzutastenden Schichten benötigt. Bei einer Kombination mit die kartesische Abtastung des k-Raums verändernden Aufnahmetechniken resultiert auch hier die Notwendigkeit zur Neuaufnahme der Referenzdaten für jeden Aufnahmeabschnitt.

Der Erfindung liegt daher die Aufgabe zugrunde, eine beschleunigte Aufnahme und/oder eine erhöhte Bildqualität bei der Kombination von unterschiedliche kartesische Abtastschemata nutzenden Aufnahmetechniken mit beschleunigten Bildgebungstechniken zu ermöglichen.

Zur Lösung dieser Aufgabe ist bei einem Verfahren der eingangs genannten Art erfindungsgemäß vorgesehen, dass, insbesondere zu Beginn der Aufnahme, ein alle im Verlauf der Aufnahme benötigten Referenzbereiche umfassender Kalibrierungsbereich des k-Raums ermittelt wird und ein Kalibrierungsdatensatz des k-Raums mit der Magnetresonanzeinrichtung durch vollständige, kartesische Abtastung des Kalibrierungsbereichs in einer Kalibrierungsmessung aufgenommen wird, wobei Referenzdaten für jeden Aufnahmeabschnitt aus dem Kalibrierungsdatensatz ermittelt werden.

Erfindungsgemäß ist mithin vorgesehen, in einem separaten Aufnahmevorgang einen Kalibrierungsdatensatz aufzunehmen, aus dessen Kalibrierungsdaten sich sämtliche für die unterschiedlichen Aufnahmeabschnitte benötigten Referenzdaten ableiten lassen. Dafür wird ein Kalibrierungsbereich des k-Raums ermittelt und abgetastet, welcher so groß ist, dass jeder bei den einzelnen Aufnahmeabschnitten benötigte, insbesondere gedrehte Referenzbereich in diesem Kalibrierungsbereich enthalten ist. Anstatt der Aufnahme von Referenzdaten in den Aufnahmeabschnitten selber, insbesondere integriert in die Aufnahme der Magnetresonanzdaten, wird eine separate Kalibrierungsmessung durchgeführt. Sollen nun aus Magnetresonanzdaten eines Aufnahmeabschnitts Magnetresonanzbilddatensätze rekonstruiert werden, werden für den entsprechenden Referenzbereich aus dem Kalibrierungsdatensatz die benötigten Referenzdaten abgeleitet.

Mithin ist eine Möglichkeit gegeben, auch für Aufnahmeabschnitte, in denen ein anderes Koordinatensystem im k-Raum, mithin eine veränderte kartesische Abtastung im k-Raum, verwendet wird, Referenzdaten abzuleiten, ohne zusätzliche, zeitaufwändige eigene Referenzmessungen vorzusehen. Dies erlaubt eine Beschleunigung bei der Kombination von derartigen Aufnahmetechniken mit beschleunigten Bildgebungstechniken und ermöglicht im Prinzip erst die sinnvolle Realisierung der Kombination einer Mehrschichttechnik mit einer solchen Aufnahmetechnik, da es bei der Mehrschichtbildgebung nicht möglich wäre, "integriert" in die Aufnahme der Magnetresonanzdaten Referenzdaten einzelner Schichten aufzunehmen, da die Magnetresonanzsignale aller Schichten entgegengenommen werden. Auch eine verbesserte Bildqualität ist möglich, da die durch den Wegfall von Referenzmessungen, die auch die Abtastung zusätzlicher Linien im k-Raum bei der Aufnahme der Magnetresonanzdaten umfassen können, zusätzliche Zeit gewonnen wird, die zur Verbesserung der Bildqualität herangezogen werden kann. Beispielsweise kann ein Blurring reduziert werden, da durch die separate Aufnahme der den Referenzdaten zugrunde zu legenden Kalibrierungsdaten die nutzbare Echozuglänge bei der Aufnahme der Magnetresonanzdaten erhöht wird.

Wie bereits erwähnt, kann als Bildgebungstechnik zweckmäßig eine Mehrschichttechnik mit gleichzeitiger Anregung mehrerer aufzunehmender Schichten und Auslesen zugehöriger Magnetresonanzdaten in einem gemeinsamen Auslesezeitraum verwendet werden (SMS). Zusätzlich oder alternativ als kann als beschleunigende Bildgebungstechnik eine parallele Bildgebungstechnik unter Verwendung mehrerer Spulenelemente einer Sende- und/oder Empfangsspule verwendet werden (PAT). Als Aufnahmetechnik wird bevorzugt eine PROPELLER-Technik (BLADE-Technik) eingesetzt, bei der die Phasenkodierungsrichtung und die Ausleserichtung um das k-Raumzentrum gedreht werden. In der Praxis bedeutet dies, dass auch die in den Aufnahmeabschnitten aufzunehmenden Linien im k-Raum entsprechend gedreht werden, genau wie der im k-Raum abgetastete Aufnahmebereich.

Bezüglich einer PROPELLER-Technik als Aufnahmetechnik sei noch angemerkt, dass der in der Kalibrierungsmessung abgetastete Kalibrierungsbereich des k-Raums dann so gewählt wird, dass für jede PROPELLER-Rotation eine für die Rekonstruktion ausreichend große Abdeckung in der momentan aktuellen Phasenkodierrichtung erzielt werden kann. Dabei sei darauf hingewiesen, dass die k-Raum-Ausdehnung bzw. Auflösung in der Ausleserichtung für die Rekonstruktion nur sekundär ist, wenn in der Rekonstruktion aus den Referenzdaten nur auf Sensitivitäten einzelner Spulenelemente rückgeschlossen werden soll, was auch mit Referenzdaten und somit einem Kalibrierungsdatensatz reduzierter räumlicher Auflösung erzielbar ist.

Zweckmäßigerweise kann die kartesische Abtastung bei der Kalibrierungsmessung der kartesischen Abtastung wenigstens eines Aufnahmeabschnitts entsprechen, für den als die Referenzdaten die Kalibrierungsdaten des Referenzbereichs aus dem Kalibrierungsdatensatz ermittelt werden. Besonders zweckmäßig dann, wenn der Kalibrierungsdatensatz zu Beginn der Aufnahme der Magnetresonanzdaten gemessen wird, entspricht die kartesische Abtastung bei der Kalibrierungsmessung der kartesischen Abtastung für den ersten Aufnahmeabschnitt, für den dann unmittelbar die entsprechenden Kalibrierungsdaten des ersten Referenzbereichs als Referenzdaten herangezogen werden können.

Bei einer eine Rotation von Gradientenrichtungen um das k-Raumzentrum beinhaltenden Aufnahmetechnik kann vorgesehen sein, dass ein aktueller Referenzbereich durch entsprechende Rotation des vor der Rotation genutzten Referenzbereichs ermittelt wird. Das bedeutet, letztlich kann der Referenzbereich innerhalb des Kalibrierungsbereichs sozusagen "mitrotiert" werden, um zu markieren, welche Kalibrierungsdaten zur Ermittlung der Referenzdaten relevant sind.

Vorzugsweise erfolgt die Ermittlung der Referenzdaten für wenigstens einen Teil der Aufnahmeabschnitte durch Regridding und/oder Interpolation. Für den beispielsweise rotierten, aktuell relevanten Referenzbereich liegen die Kalibrierungsdaten in vielen Fällen in einer falschen Rasterung und/oder an den falschen Positionen vor. Mithin ist es zweckmäßig, Referenzdaten der korrekten, gewünschten Rasterung, die durch die kartesische Abtastung des Aufnahmeabschnitts definiert wird, durch Regridding, also Zuordnung zu den korrekten Gitterpunkten der Abtastung in dem Aufnahmeabschnitt, und/oder Interpolation aus den Kalibrierungsdaten möglichst korrekte, passende Referenzdaten abzuleiten. Dabei können verschiedene Interpolationstechniken eingesetzt werden. Beispielsweise kann zum Regridding und/oder zur Interpolation die Methode des "Grappa Operator Gridding" (GROG) zweckmäßig herangezogen werden. Der Vorteil einer Umrechnung auf das korrekte, benötigte Raster ist insbesondere, dass nachfolgende Rekonstruktionsschritte der Magnetresonanzdaten unabhängig von der Verwendung des Kalibrierungsdatensatzes wie bisher üblich ausgeführt werden können.

Wie bereits erwähnt, kann die durch Wegfall einzelner Referenzmessungen für Referenzdaten der Aufnahmeabschnitte frei werdende Zeit zur Beschleunigung der Bildaufnahme insgesamt eingesetzt werden. Eine zweckmäßige Weiterbildung der vorliegenden Erfindung sieht jedoch vor, dass ein durch Wegfall einzelner Referenzmessungen für Referenzdaten der Aufnahmeabschnitte frei werdender Aufnahmezeitraum wenigstens teilweise zur Erhöhung der Auflösung und/oder der Bildschärfe bei der Abtastung des k-Raums verwendet wird. Im Beispiel einer konventionellen PROPELLER-Technik mit PAT und/oder SMS ist es üblich, für jeden Echo-Zug, insbesondere also jedem Aufnahmeabschnitt/jede Drehung des Koordinatensystems (im k-Raum) neue Referenzdaten, gegebenenfalls kombiniert mit der Aufnahme der Magnetresonanzdaten, aufzuzeichnen. Durch die zusätzliche Aufnahme von Referenzdaten wird die Gesamtaufnahmezeit und ggf. Echo-Zeit mithin verlängert. Wird nun, wie erfindungsgemäß vorgesehen, der Kalibrierungsdatensatz getrennt aufgenommen und werden die Referenzdaten aus diesem abgeleitet, kann entweder die Echo-Zeit entsprechend reduziert werden und/oder eine höhere k-Raum Abtastung bei gleicher oder etwas kürzerer/längerer Echo-Zeit realisiert werden, um die Auflösung/Bildschärfe zu verbessern. Mithin bietet das erfindungsgemäße Verfahren sowohl die Möglichkeit, schnellere Gesamtaufnahmezeiten als auch eine verbesserte Bildqualität zu erreichen.

Neben dem Verfahren betrifft die Erfindung auch eine Magnetresonanzeinrichtung, aufweisend eine zur Durchführung des erfindungsgemäßen Verfahrens ausgebildete Steuereinrichtung. Sämtliche Ausführungen bezüglich des erfindungsgemäßen Verfahrens lassen sich analog auf die erfindungsgemäße Magnetresonanzeinrichtung übertragen, mit welcher mithin ebenso die bereits genannten Vorteile erhalten werden können. Die Steuereinrichtung kann dabei neben der üblicherweise ohnehin vorgesehenen Sequenzeinheit zur Realisierung von Bildgebungsmaßnahmen, die dann auch die Kalibrierungsmessung realisieren kann, eine Kalibrierungsbereichsbestimmungseinheit zur Bestimmung des Kalibrierungsbereichs und eine Referenzdatenermittlungseinheit zur Ermittlung von Referenzdaten für einen Aufnahmeabschnitt aus dem Kalibrierungsdatensatz aufweisen.

Ein erfindungsgemäßes Computerprogramm ist beispielsweise direkt in einem Speicher einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen aufweist, welche zumindest ein genanntes Computerprogramm umfassen und derart ausgestaltet sind, dass sie bei Verwendung des Datenträgers in einer Steuereinrichtung einer Magnetresonanzeinrichtung ein erfindungsgemäßes Verfahren durchführen. Bei dem Datenträger kann es sich insbesondere um einen nichttransienten Datenträger, beispielsweise eine CD-ROM, handeln.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: einen Ablaufplan eines Ausführungsbeispiels des erfindungsgemäßen Verfahrens,
- Fig. 2: eine Skizze zur Erläuterung veränderter Aufnahmeund Referenzbereiche bei einer PROPELLER-Technik als Aufnahmetechnik,
- Fig. 3: eine Skizze zur Bestimmung des Kalibrierungsbereiches,
- Fig. 4: eine das Verfahren erläuternde weitere Skizze, und
- Fig. 5: eine Prinzipskizze einer erfindungsgemäßen Magnetresonanzeinrichtung.

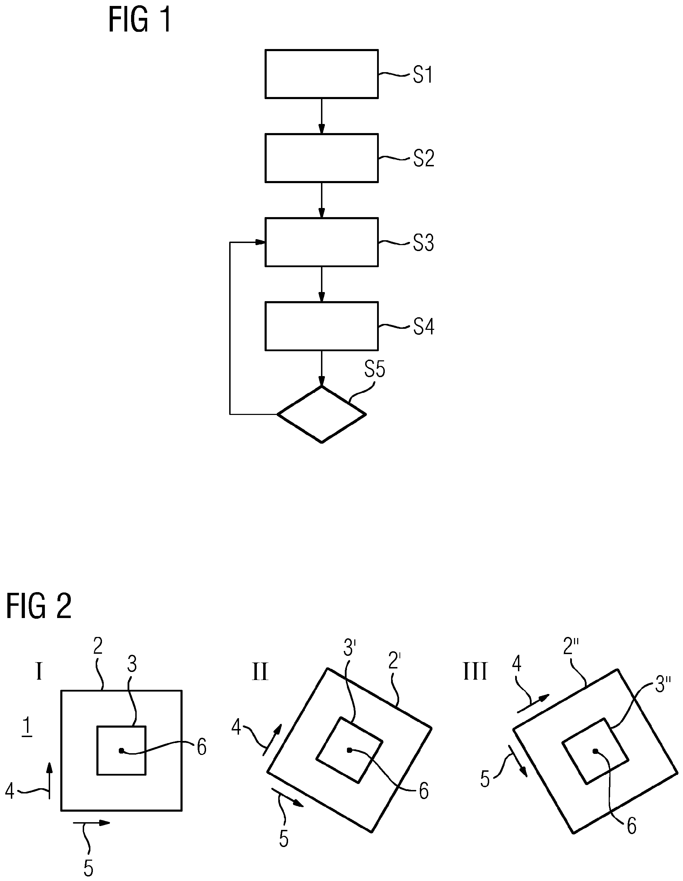

Figur 1 zeigt einen Ablaufplan eines Ausführungsbeispiels des erfindungsgemäßen Verfahrens. Dabei wird vorliegend eine PROPELLER-Technik als Aufnahmetechnik mit wenigstens einer beschleunigenden Bildgebungstechnik, umfassend eine parallelen Bildgebungstechnik (PAT) und/oder eine Mehrschichtbildgebungstechnik (SMS), kombiniert. Für die beschleunigenden Bildgebungstechniken sind Referenzdaten erforderlich, die aus einem relevanten Referenzbereich bei richtiger Rasterung gemäß der aktuellen Rotation des Koordinatensystems des k-Raums im entsprechenden Aufnahmeabschnitt vorliegen sollten. Um dies zu erreichen, ohne dass Referenzmessungen innerhalb oder zusätzlich zu der Aufnahme von Magnetresonanzdaten in den einzelnen Aufnahmeabschnitten selbst gemessen werden müssen, wird im Schritt S1, vorliegend vor Beginn der Aufnahme der Magnetresonanzdaten, ein Kalibrierungsbereich bestimmt und ein Kalibrierungsdatensatz für diesen Kalibrierungsbereich im Schritt S2 aufgenommen. Aus diesem Kalibrierungsdatensatz sollen später dann Referenzdaten für alle Aufnahmeabschnitte von Magnetresonanzdaten, in denen ein unterschiedliches Abtastschema des k-Raums verwendet wird, mithin insbesondere ein anderes Koordinatensystem mit anderen, hier gedrehten, Gradientenrichtungen, abgeleitet werden können.

Figur 2 illustriert hierzu im k-Raum 1 für verschiedene Aufnahmeabschnitte I, II und III die Lage zum einen des Aufnahmebereichs 2, 2', 2" zum anderen die Lage des innerhalb des jeweiligen Aufnahmebereichs 2, 2', 2" liegenden Referenzbereichs 3, 3', 3", aus dem Referenzdaten benötigt werden. Dabei zeigen Pfeile die Phasenkodierrichtung 4 und die Ausleserichtung 5 (Readout - RO)an. Wie leicht ersichtlich ist, wird für die unterschiedlichen Aufnahmeabschnitte I, II und III das durch die Phasenkodierrichtung 4 und die Ausleserichtung 5 gegebene Koordinatensystem um das k-Raumzentrum 6 rotiert. Nachdem der k-Raum 1 im Aufnahmebereich 2, 2', 2" entlang von Linien in der Ausleserichtung 5 abgetastet wird, ändert sich auch deren Orientierung entsprechend.

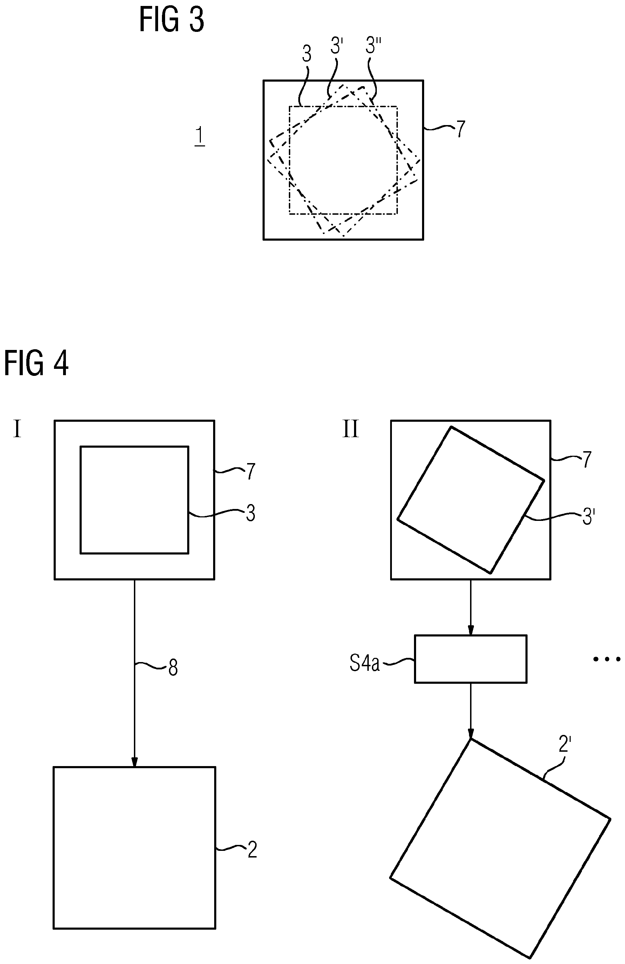

Aus einem Kalibrierungsdatensatz soll nun Referenzdaten für alle auftretenden Referenzbereiche 3, 3', 3" abgeleitet werden, weshalb, vergleiche Figur 3, im Schritt S1 ein Kalibrierungsbereich 7 ermittelt wird, innerhalb dessen alle Referenzbereiche 3, 3', 3" liegen, wie dargestellt.

Für diesen Kalibrierungsbereich 7 werden nun im Schritt S2 Kalibrierungsdaten, insbesondere unter Verwendung der der PROPELLER-Aufnahmetechnik zu Grunde liegenden Magnetresonanzsequenz oder einer zugeordneten Referenzdatensequenz, aufgenommen, wobei vorliegend die Phasenkodierrichtung 3 und die Ausleserichtung 5 im k-Raum 1 im Schritt S2 so gewählt werden, dass sie den entsprechenden Richtungen im ersten Aufnahmeabschnitt I entsprechen.

In einem Schritt S3, vergleiche Figur 1, beginnt nun ein erster Aufnahmeabschnitt I. Es werden entsprechend Magnetresonanzdaten aufgenommen, ohne dass zusätzliche Referenzmessungen für Referenzdaten, sei es integriert in die Aufnahme der Magnetresonanzdaten oder zusätzlich dazu, nötig wären. Mithin wird Aufnahmezeit eingespart, die zum einen zur Verkürzung der Gesamtmessung herangezogen werden kann, zum anderen aber auch zur Aufnahme zusätzlicher Magnetresonanzdaten/zur Verlängerung der Echozeiten genutzt werden kann, um die Bildqualität zu erhöhen.

Bei der Rekonstruktion für einen Aufnahmeabschnitt, hier direkt anschließend im Schritt S4 gezeigt, welche jedoch auch zu einem späteren Zeitpunkt erfolgen kann, werden nun die passenden Referenzdaten in dem passenden Referenzbereich 3, 3', 3", aus dem Kalibrierungsdatensatz ermittelt, wie dies durch Figur 4 angedeutet ist. Für den Aufnahmeabschnitt I stimmt die kartesische Abtastung des k-Raums 1, mithin die Richtungen 4 und 5, mit denen bei der Aufnahme des Kalibrierungsdatensatzes verwendeten überein, so dass einfach die Kalibrierungsdaten in dem Referenzbereich 3 unmittelbar, wie durch den Pfeil 8 angedeutet, als Referenzdaten verwendet werden können.

In einem späteren Aufnahmeabschnitt II allerdings stimmen die Phasenkodierrichtung 4 und die Ausleserichtung 5 der Aufnahme des Kalibrierungsdatensatzes nicht mehr mit den aktuell verwendeten Richtungen 4, 5, überein, so dass die Kalibrierungsdaten aus dem dann aktuellen Referenzbereich 3' in einem Schritt S4a als Unterschritt des Schrittes S4 zunächst mittels Interpolation und Regridding in das korrekte kartesische Abtastraster, welches bei der Aufnahme der Magnetresonanzdaten im Aufnahmebereich 2' verwendet wird, überführt werden. Die so gebildeten Referenzdaten, wobei hier beispielsweise das "GRAPPA Operator Gridding"-Verfahren (GROG) verwendet werden kann, werden dann bei der Rekonstruktion unter Verwendung der Magnetresonanzdaten des entsprechenden Aufnahmeabschnitts II verwendet. Entsprechendes gilt für weitere Aufnahmeabschnitte.

Wie durch den Schritt S5 angedeutet, vergleiche Figur 1, wiederholen sich die Schritte S3 und S4 dann, bis alle vorgesehenen Aufnahmeabschnitte durchgeführt wurden.

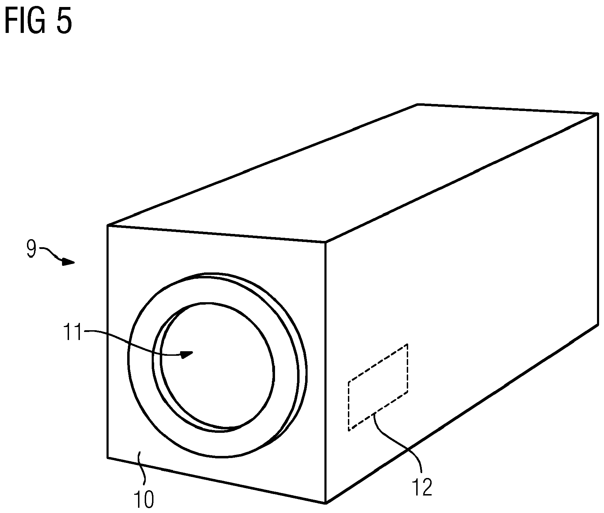

Figur 5 zeigt schließlich eine Prinzipskizze einer erfindungsgemäßen Magnetresonanzeinrichtung 9, die trotz der vereinfachten Darstellung alle üblichen Komponenten aufweist. Eine Hauptmagneteinheit 10 definiert eine Patientenaufnahme 11, in die ein Patient mittels einer Patientenliege eingefahren werden kann. Die Patientenaufnahme 11 umgebend können eine Gradientenspulenanordnung und eine Hochfrequenzspulenanordnung vorgesehen sein.

Der Betrieb der Magnetresonanzeinrichtung 9 wird durch eine Steuereinrichtung 12 gesteuert, die auch zur Durchführung des erfindungsgemäßen Verfahrens ausgebildet ist und hierfür insbesondere eine Kalibrierungsbereichsbestimmungseinheit zur Realisierung des Schrittes S1, eine Sequenzeinheit zur Realisierung der Schritte S2 und S3 und eine Referenzdatenermittlungseinheit zur Ermittlung entsprechender Unterschritte des Schrittes S4 aufweisen kann.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Betrieb einer Magnetresonanzeinrichtung (9) bei der Aufnahme von Magnetresonanzdaten mit einer Aufnahmetechnik, bei der die kartesische Abtastung des k-Raums (1), insbesondere durch eine Rotation von Gradientenrichtungen um das k-Raumzentrum (6), für unterschiedliche Aufnahmeabschnitte jeweils eines Teils der Magnetresonanzdaten unterschiedlich vorgenommen wird, wobei die Aufnahmetechnik mit einer beschleunigenden Bildgebungstechnik kombiniert wird, für welche für jede einzelne abzutastende Schicht einen Referenzbereich (3, 3', 3") um das k-Raumzentrum (6) vollständig beschreibende Referenzdaten verwendet werden, **dadurch gekennzeichnet, dass**, insbesondere zu Beginn der Aufnahme, ein alle im Verlauf der Aufnahme benötigten Referenzbereiche (3, 3', 3") umfassender Kalibrierungsbereich (7) des k-Raums (1) ermittelt wird und ein Kalibrierungsdatensatz des k-Raums (1) mit der Magnetresonanzeinrichtung (9) durch vollständige, kartesische Abtastung des Kalibrierungsbereichs (7) in einer Kalibrierungsmessung aufgenommen wird, wobei Referenzdaten für jeden Aufnahmeabschnitt aus dem Kalibrierungsdatensatz ermittelt werden.

2. Verfahren nach Anspruch 1, **dadurch gekennzeichnet, dass** als Bildgebungstechnik eine Mehrschichttechnik mit gleichzeitiger Anregung mehrerer aufzunehmender Schichten und Auslesen zugehöriger Magnetresonanzdaten in einem gemeinsamen Auslesezeitraum und/oder eine parallele Bildgebungstechnik unter Verwendung mehrerer Spulenelemente einer Sende- und/oder Empfangsspule verwendet werden und/oder als Aufnahmetechnik eine PROPELLER-Technik verwendet wird.

3. Verfahren nach Anspruch 1 oder 2, **dadurch gekennzeichnet, dass** die kartesische Abtastung bei der Kalibrierungsmessung der kartesischen Abtastung wenigstens eines Aufnahmeabschnitts entspricht, für den als die Referenzdaten die Kalibrierungsdaten des Referenzbereichs (3, 3', 3") aus dem Kalibrierungsdatensatz ermittelt werden.

4. Verfahren nach einem der vorangehenden Ansprüche, **dadurch gekennzeichnet, dass** bei einer eine Rotation von Gradientenrichtungen um das k-Raumzentrum (6) beinhaltenden Aufnahmetechnik ein aktueller Referenzbereich (3, 3', 3") durch entsprechende Rotation des vor der Rotation genutzten Referenzbereiches ermittelt wird.

5. Verfahren nach einem der vorangehenden Ansprüche, **dadurch gekennzeichnet, dass** die Ermittlung der Referenzdaten für wenigstens einen Teil der Aufnahmeabschnitte durch Regridding und/oder Interpolation erfolgt.

6. Verfahren nach einem der vorangehenden Ansprüche, **dadurch gekennzeichnet, dass** ein durch Wegfall einzelner Referenzmessungen für Referenzdaten der Aufnahmeabschnitte freiwerdender Aufnahmezeitraum wenigstens teilweise zur Erhöhung der Auflösung und/oder der Bildschärfe bei der Abtastung des k-Raums (1) verwendet wird.

7. Magnetresonanzeinrichtung (9), aufweisend eine zur Durchführung eines Verfahrens nach einem der vorangehenden Ansprüche ausgebildete Steuereinrichtung (12).

8. Computerprogramm, welches die Schritte eines Verfahrens nach einem der Ansprüche 1 bis 6 durchführt, wenn es auf einer Steuereinrichtung (12) einer Magnetresonanzeinrichtung (9) ausgeführt wird.

9. Elektronisch lesbarer Datenträger, auf dem ein Computerprogramm nach Anspruch 8 gespeichert ist.
